(19) **Europäisches Patentamt**

**European Patent Office**

**Office européen des brevets**

(11) **EP 1 493 126 B1**

(12) **FASCICULE DE BREVET EUROPEEN**

(45) Date de publication et mention
de la délivrance du brevet:
**25.10.2006 Bulletin 2006/43**

(21) Numéro de dépôt: **03727581.5**

(22) Date de dépôt: **11.03.2003**

(51) Int Cl.:
**G06K 19/073** (2006.01)

(86) Numéro de dépôt international:
**PCT/FR2003/000778**

(87) Numéro de publication internationale:
**WO 2003/077194 (18.09.2003 Gazette 2003/38)**

(54) **DISPOSITIF ELECTRONIQUE SECURISE**

**GESICHERTE ELEKTRONISCHE VORRICHTUNG**

**SECURE ELECTRONIC DEVICE**

(84) Etats contractants désignés:
**AT BE BG CH CY CZ DE DK EE ES FI FR GB GR
HU IE IT LI LU MC NL PT RO SE SI SK TR**

(30) Priorité: **13.03.2002 FR 0303102**

(43) Date de publication de la demande:
**05.01.2005 Bulletin 2005/01**

(73) Titulaire: **COMMISSARIAT A L'ENERGIE
ATOMIQUE**
**75752 Paris 15ème (FR)**

(72) Inventeurs:
• **VACHERAND, François**
**F-38800 Le PONT-de-CLAIX (FR)**
• **DELAPIERRE, Gilles**
**F-38180 SEYSSINS (FR)**
• **BLOCH, Didier**
**F-38330 BIVIERS (FR)**

(74) Mandataire: **Poulin, Gérard**
**Société BREVATOME**
**3, rue du Docteur Lancereaux**
**75008 Paris (FR)**

(56) Documents cités:
**DE-A- 3 920 957    FR-A- 2 805 116
US-A- 3 725 671    US-A- 3 882 323
US-A- 5 060 261    US-A- 5 883 429
US-A- 5 998 858**

## Description

Domaine technique

La présente invention concerne un dispositif électronique sécurisé, par exemple un circuit pour carte à puce.

Etat de la technique antérieure

L'alimentation des cartes à puce de l'art connu est réalisée lors de l'introduction de celles-ci dans un lecteur. Une protection active de celles-ci ne peut avoir lieu qu'à ce moment là. Ces cartes n'ont, en effet, aucun moyen pour détecter une attaque invasive lorsqu'elles ne sont pas alimentées. Une attaque en "rétro-technique", ou "reverse engineering", permettant à une personne malhonnête de récupérer les informations confidentielles mémorisées sur cette carte, par exemple les clés de cryptage et le code d'identification personnel, a donc toutes les chances de réussir.

L'arrivée annoncée de micro-sources d'énergie permet d'envisager d'autres scénarios de protection dans lesquels le circuit électronique de la carte à puce assure une fonction minimum de veille active. Selon le résultat de cette veille, le circuit peut alors réagir et, grâce à l'énergie embarquée, enclencher des contre-mesures.

Pour détecter toute intrusion dommageable voire malveillante dans un circuit pour carte à puce, il est connu, par exemple comme décrit dans le document référencé [1] en fin de description, d'entourer ce circuit d'un maillage de conducteurs électriques permettant de détecter une ouverture dans l'enveloppe ainsi formée. Mais une telle détection ne peut se faire que si le circuit est alimenté.

Comme décrit dans le document référencé [2], les contre mesures se résument, jusqu'à présent, à l'effacement des mémoires où sont sauvegardées les informations confidentielles telles que les clés. Toutefois la disparition des clés ne correspond pas alors à la destruction de toutes les informations confidentielles. Le document US 5 998 858 divulgue le préambule de la revendication 1.

L'invention a pour objectif de résoudre ce problème de protection en mettant en oeuvre une contre-mesure active en cas d'attaque intrusive dans un dispositif électronique sécurisé tel qu'un circuit intégré pour carte à puce, cette contre-mesure visant à détruire tout ou partie des blocs électroniques mettant en oeuvre les fonctions sensibles du circuit.

Exposé de l'invention

La présente invention concerne un dispositif électronique sécurisé comprenant un circuit électronique contenant des informations à protéger selon la revendication 1.

Avantageusement les moyens de mise à feu, sont par exemple une amorce électrique ou une mèche.

Le dispositif de l'invention peut être entièrement recouvert par une micro-charge pyrotechnique, ou une micro-charge et une amorce peuvent être associées à différents éléments du circuit.

Avantageusement, le circuit de l'invention constitue une puce dans laquelle les micro-charges et amorces sont situées dans le substrat de cette puce, par exemple en étant disposées dans des micro-cartes existant en face arrière du substrat, ou dans la couche d'implantation des transistors, ou dans une couche métal de celle-ci.

Au moins un ensemble micro-charge/amorce peut être associé à un micro-fusible.

Le dispositif de l'invention peut également comporter au moins une micro-bobine couplée à distance à une micro-bobine d'un circuit résonant intégrée dans une micro-charge.

La source d'énergie peut être intégrée au circuit électronique. Elle peut également être un accumulateur.

Au moins un capteur peut être intégré au circuit électronique. Tout le dispositif peut également être intégré au circuit électronique.

Au moins un capteur peut être un capteur apte à mesurer une grandeur physique caractérisant le circuit ou l'environnement du circuit, ou un capteur apte à mesurer une grandeur physique caractérisant la communication entrant ou sortant dudit dispositif, ou un capteur apte à mesurer le niveau d'énergie de la source d'énergie afin d'émettre un signal d'avertissement de demande de recharge ou d'activation du dispositif de protection, ou un capteur apte à mesurer une grandeur physique caractérisant la liaison électrique source d'énergie - dispositif logique de prise de décision.

Un tel dispositif, qui peut être un circuit pour carte à puce, permet d'établir une veille active, c'est-à-dire de procéder à des mesures permanentes de paramètres physiques caractérisant un fonctionnement normal puis à déclencher quand cela s'avère nécessaire, la destruction de tout ou partie des blocs électroniques mettant en oeuvre les fonctions sensibles de celui-ci.

Brève description des dessins

La figure 1 illustre le dispositif de l'invention.
La figure 2 illustre un mode de réalisation particulier du dispositif de l'invention.
La figure 3 illustre différents types d'associations charge/amorce pouvant être utilisé dans le dispositif de l'invention.
Les figures 4 à 10 illustrent différents exemples de mise en oeuvre du dispositif de l'invention.

Exposé détaillé de modes de réalisation

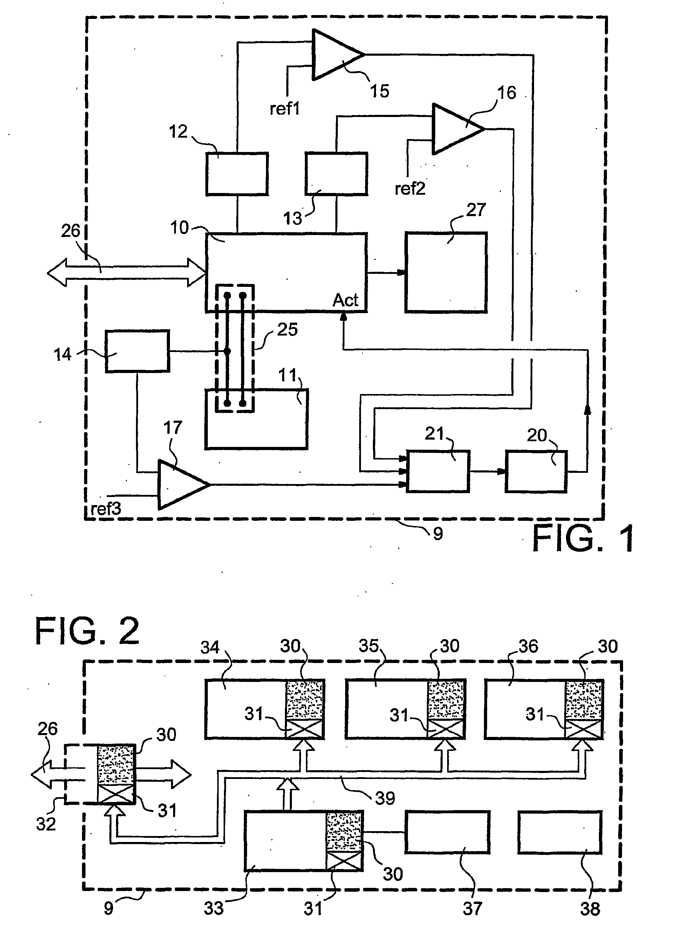

Comme illustré sur la figure 1 le dispositif de l'invention 9 comprend :

- une source ou micro-source d'énergie 11,
- un circuit électronique intégré 10, contenant par exemple un processeur logique et une mémoire non volatile contenant des informations à protéger,
- au moins un capteur apte à mesurer une grandeur physique déterminée et à fournir une valeur représentative de cette grandeur, ces capteurs étant ici au nombre de trois : 12, 13, 14,
- des moyens de comparaison de chaque valeur mesurée à un seuil prédéfini, réalisés ici par trois comparateurs 15, 16, 17 recevant respectivement sur une de leurs deux entrées un signal ref1, ref2, ref3, et sur l'autre entrée la sortie du capteur correspondant 12, 13 ou 14,
- un dispositif 20 de protection des informations contenues dans le circuit 10, dont la sortie est reliée par exemple à une entrée Act (Activation de destruction locale ou globale) du circuit intégré 10, apte à détruire tout ou partie du circuit 9 grâce à des moyens pyrotechniques 27,
- un dispositif logique 21 de prise de décision, apte à activer le dispositif de protection 20, recevant les signaux de sortie des comparateurs 15, 16 et 17.

Ce dispositif électronique sécurisé selon l'invention met donc en oeuvre deux fonctions actives :

- une fonction de détection d'intrusion,
- une fonction de mise à feu qui permet d'amorcer une micro-charge pyrotechnique locale ou globale à l'aide de l'énergie électrique stockée dans une micro-batterie,

de manière permanente, c'est-à-dire qu'il soit introduit ou non dans un lecteur.

On va, à présent, prendre en considération chacun de ces éléments du dispositif de l'invention.

Ce qui doit être protégé est de l'information sensible comme des données sauvegardées dans une mémoire électronique (clef de cryptage, mot de passe...) ou l'architecture même du circuit électronique.

Le circuit 10 contenant cette information est celui que l'on trouve de manière classique dans une carte à puce. Il contient, par exemple, les fonctions suivantes :

- un processeur central (CPU),
- une mémoire à lecture seule (ROM),
- une mémoire de travail volatile (RAM),
- une mémoire de stockage non volatile (EEPROM),
- une interface de communication, avec ou sans contact, qui fournit :

  • l'alimentation du circuit (externe),
  • un canal de communication bidirectionnel,
  • éventuellement une horloge,
  • éventuellement un signal de remise à zéro du processeur.

Elle peut également contenir d'autres fonctions par exemple celles des capteurs, des comparateurs, de la logique, de la communication.

La source d'énergie 11 peut être une micro- ou mini-batterie : pile bouton, pile ultra-plate, pile intégrée ... Elle doit permettre l'alimentation en énergie du circuit de l'invention pour la mise en oeuvre des deux fonctions de détection active d'intrusion, et d'activation de la protection par mise à feu d'une ou plusieurs micro-charges.

Cette source d'énergie 11 peut également être réalisée en utilisant des procédés issus de la micro-électronique, par exemple en ajoutant plusieurs niveaux technologiques au-dessus de ceux dédiés classiquement à la réalisation du circuit intégré 10 : ces niveaux permettant de fabriquer de manière collective la source d'énergie 11, la connectique et l'électrolyte à l'état solide.

La source d'énergie 11 peut également être externe au circuit intégré 10.

Les capteurs 12, 13 et 14 peuvent être :

• des capteurs de surveillance de l'environnement : de tels capteurs doivent vérifier si les conditions nominales d'utilisation (circuit alimenté au travers de la voie de communication) et de repos du circuit sont bien vérifiées. Un écart détecté avec une valeur référence peut signifier alors qu'il y a une tentative d'intrusion. Ces capteurs peuvent être notamment :

  - un capteur de température qui permet de protéger la source d'énergie 11,
  - un capteur de rayons ultra-violets qui permet de détecter une agression sur la mémoire EEPROM par exemple,
  - un capteur de rayons X qui permet de détecter une agression de type radiographie du circuit intégré 10,
  - un maillage de protection qui permet de détecter une tentative de "reverse engineering",
  - un capteur de champ électrique ou magnétique : antenne, etc..

• des capteurs de surveillance du lien de communication 26 du circuit 9 avec l'extérieur. De tels capteurs réalisent une surveillance électronique de ce qui se passe sur le lien de communication 26. On peut citer entre autres :

  - la surveillance de la tension d'alimentation,
  - la surveillance du signal d'horloge.

Il est également possible d'avoir d'autres fonctions permettant :

• une recharge de la source d'énergie 11, si celle-ci est un accumulateur, par le lien de communication. On peut intégrer à l'intérieur du circuit de l'invention une fonction de recharge de cet accumulateur, que la communication se fasse par contact ou sans contact.

• une activation/désactivation du circuit de l'invention. Dans certaines applications il peut être intéressant de commander l'utilisation de la source d'énergie. Une télécommande d'arrêt/marche est alors disponible via le lien de communication.

• une protection supplémentaire, par un étage situé en amont de la mise à feu des moyens pyrotechniques 27, formant une position de sécurité, par exemple pour le transport, qui permet de verrouiller temporairement la mise à feu,

• une mémorisation supplémentaire permettant de sauvegarder, après destruction, des informations venant par exemple des capteurs permettant d'expliquer le circonstances de la destruction : par exemple date, paramètre perturbé...

Sur la figure 1, le premier et le second capteur 12, 13 sont par exemple des capteurs ultraviolet et rayons X, et le troisième capteur 14 peut être un capteur permettant la mesure d'impédance de la liaison galvanique 25 entre la source 11 et l'unité de traitement 10.

Les moyens de comparaison ont pour rôle d'inspecter régulièrement les différents paramètres issus des capteurs 12, 13, 14 et de les comparer à différentes valeurs de référence ref1, ref2 et ref3.

Les comparateurs 15, 16 et 17 sont, par exemple, des amplificateurs opérationnels ; les valeurs de référence ref1, ref2 et ref3 étant soit internes soit imposées par l'extérieur ou par le microprocesseur.

Les moyens de comparaison peuvent également réaliser :

- d'une part une détection à un niveau d'énergie faible (premier seuil) pour constituer une alarme pour intervention de maintenance. Dans le cas où la source d'énergie est une batterie rechargeable, il s'agit de détecter le niveau de charge en deçà duquel il faut émettre un signal d'avertissement de demande de recharge,

- d'autre part une détection d'un niveau d'énergie critique (deuxième seuil) pour constituer une alerte et éventuellement une mise en oeuvre de la protection. L'énergie restante en deçà de ce deuxième seuil étant tout juste suffisante pour activer la protection, il s'agit de la déclencher afin de garantir la sécurité.

Ces différents éléments peuvent constituer une zone dite protégée qui est supposée constituée par un montage réputé insécable. Les liaisons entre les différentes fonctions (puce, source d'énergie, capteurs) sont alors valides en permanence et ne peuvent pas faire l'objet d'une attaque ou d'une modification. Mais il est également possible :

- soit de détecter la déconnexion d'un capteur 12, 13 ou 14 en vérifiant que la mesure directe est erronée, ou en réalisant des moyens d'étalonnage,

- soit de pallier la déconnexion de la source d'énergie 11 en transmettant l'énergie sous d'autres façons, au moins momentanément.

Le circuit de protection 20 a pour but de protéger toute information confidentielle. Il met en oeuvre une contre-mesure active en cas d'attaque intrusive. Cette contre-mesure vise à réaliser une destruction de tout ou partie des blocs électroniques mettant en oeuvre les fonctions sensibles du circuit 9. La source d'énergie 11 qui se trouve dans le circuit électronique 9 assure donc une veille active continue et le déclenchement des contre-mesures de façon sécurisée.

Cette destruction est assurée par une micro-explosion pulvérisant la ou les fonctions à protéger. Il s'agit donc d'au moins une micro-charge amorcée par l'énergie stockée à bord par exemple dans une micro-batterie. Après une telle destruction, une attaque en "reverse engineering" n'est plus possible.

Cette micro-charge peut être globale ou locale. Dans le premier cas, le circuit 9 est entièrement recouvert par une micro-charge pyrotechnique, tout le circuit étant alors détruit lors d'une explosion. Dans le second cas, les micro-charges sont localisées en différents points sensibles, comme illustré sur la figure 2.

Sur cette figure 2, une micro-charge 30 et une amorce (mise à feu électrique) 31 sont associées à différents éléments du circuit de l'invention, à savoir :

- les plots d'entrée-sortie 32,
- la logique sécurité 33,
- la mémoire clés 34,
- le processeur de cryptographie 35,
- les capteurs anti-intrusion 36.

Sur cette figure 2 sont également illustrés une mémoire trace 37, une micro-source d'énergie 38 et le signal de mise à feu 39.

Dans ce second cas le déclenchement des amorces 31 se fait soit par un signal électrique, soit par une micro-mèche intégrée reliant les différentes micro-charges pyrotechniques 30.

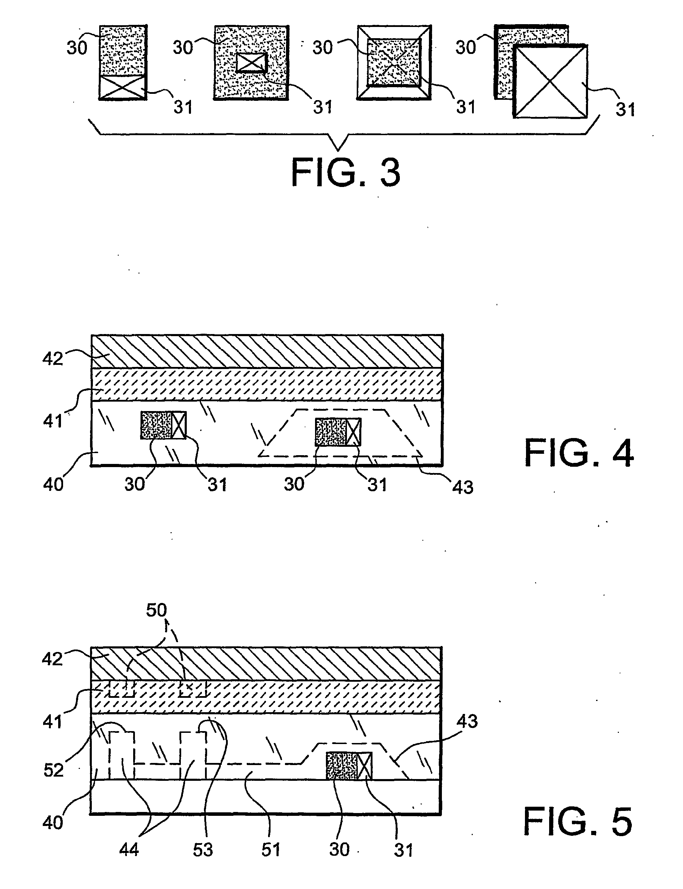

Sur la figure 3 sont illustrés différents types d'associations micro-charge 30/amorce 31.

Différents exemples de mise en oeuvre

Le dépôt des matériaux pyrotechniques se fait essentiellement par sérigraphie ou distribution goutte à goutte. On peut potentiellement réaliser les micro-charges 30 et amorces 31 à plusieurs niveaux de la puce correspondant au circuit 9 de l'invention. On a ainsi les différentes possibilités de mise en oeuvre suivantes.

a) Mise en oeuvre dite "above IC"

Le matériau pyrotechnique est déposé sur circuit et, par exemple, c'est l'élévation de température qui détruit le circuit.

b) Mise en oeuvre dite "inside IC"

Dans une première variante, les micro-charges pyrotechniques 30 et amorces 31 sont situées dans le substrat 40, comme illustré sur la figure 4 ; les deux autres couches représentées étant le niveau dopage 41 et le niveau métal 42. On peut alors astucieusement utiliser des micro-cavités 43 existant en face arrière pour placer les micro-charges 30 et les amorces 31 ou pour guider et concentrer sur un point précis la force mécanique au moment de l'explosion. La figure 5 illustre, ainsi, un exemple de mise en oeuvre du dispositif de l'invention comprenant des zones à protéger 50, et une micro-cavité 43 reliée à deux autres micro-cavités 44 au moyen d'un canal 51. Les petites surfaces prédéfinies 52 et 53 de ces micro-cavités 44 permettent de concentrer la force mécanique au moment de l'explosion en direction de ces zones 50 : on obtient, en effet, un rapport

$$\frac{\text{volume de charge}}{\text{surface à détruire}} \text{ important.}$$

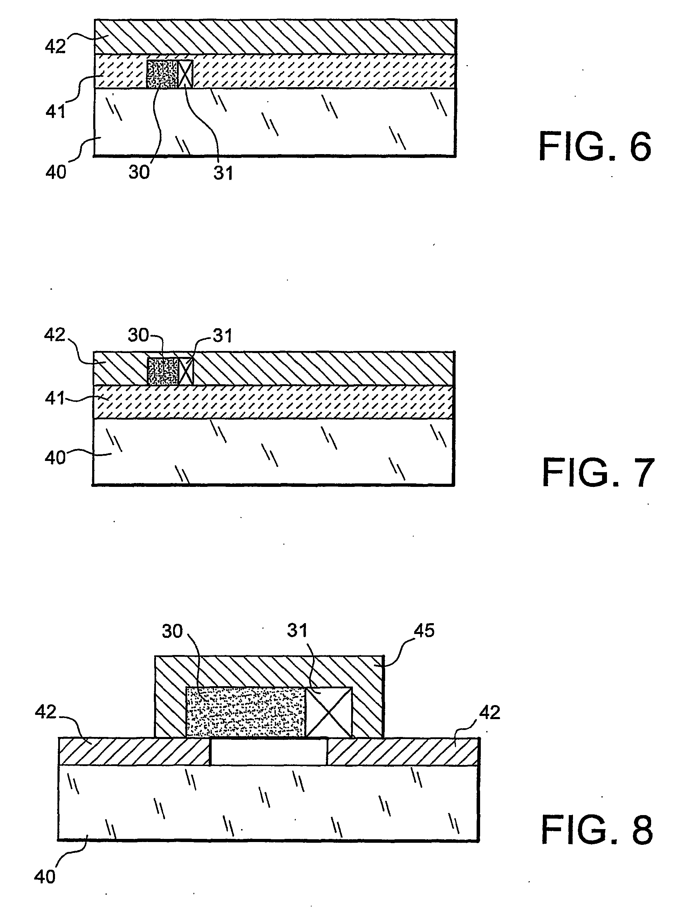

Dans une seconde variante, les micro-charges pyrotechniques 30 et les amorces 31 sont situées au niveau des transistors dans la couche 41 comme illustré sur la figure 6.

Dans une troisième variante, les micro-charges pyrotechniques 30 et les amorces 31 sont situées au niveau 42 des couches de métal, comme illustré sur la figure 7.

c) Mise en carte dite "micro-fusible"

Dans cet exemple de mise en oeuvre, on implante des fonctions micro-fusibles. Un exemple de micro-fusible pyrotechnique 45 est illustré sur la figure 8, les deux couches représentées étant le niveau métal 42, et le substrat 40.

d) Mise en oeuvre dite "outside IC"

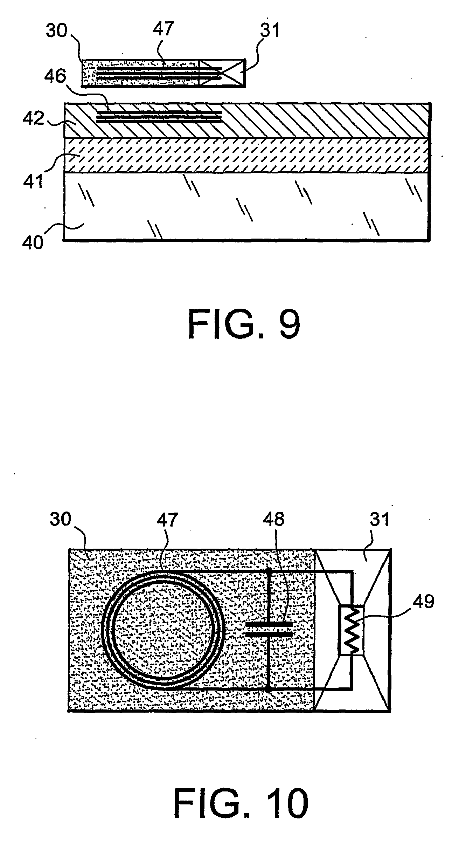

Dans le cas d'un circuit 9 réalisé en technologie classique et pour ne pas modifier le procédé de fabrication dudit circuit, on peut envisager de placer la charge explosive 30, 31 à l'extérieur et de la déclencher à distance, par exemple par un moyen sans contact par couplage inductif. Dans ce cas, comme illustré sur la figure 10, la charge explosive est constituée d'une micro-charge 30 et d'une amorce 31 reliée à un circuit résonnant constitué, entre autre, d'une micro-bobine 47. Une micro-bobine 46 située dans la couche 42 de taille équivalente réalisée avec la ou les dernières couches métal permet un déclenchement de la mise à feu.

Comme représenté sur la figure 10, en vue de dessus, on peut intégrer alors dans la micro-charge pyrotechnique 30 un circuit résonnant constitué de la micro-bobine 47, d'une capacité d'accord 48, d'une résistance chauffante 49 permettant de déclencher l'amorce 31.

REFERENCES

[1] "Design principles for tamper-resistant smartcard processors" de Oliver Kömmerling et Markus G. Kuhn (Proceedings of the USENIX Workshop on smartcard technology, Chicago, Illinois, USA, 10-11 mai 1999, pages 1 à 12)

[2] "Tamper resistance-a cautionary note" de Ross Anderson et Markus Kuhn (Second USENIX Workshop on Electronic Commerce Proceedings, Oakland, Californie, 18-21 novembre 1996, pages 1 à 11).

**Revendications**

1. Dispositif électronique sécurisé comportant au moins un circuit électronique contenant des informations à protéger comprenant :

   - une source d'énergie (11),
   - au moins un capteur (12, 13, 14) apte à mesurer une grandeur physique déterminée et à fournir une valeur représentative de cette grandeur,
   - des moyens (15, 16, 17) de comparaison de chaque valeur à au moins un seuil prédéfini (ref1, ref2, ref3) délivrant des signaux résultats,
   - un dispositif (20) de protection des informations comprenant des moyens de commande de destruction d'au moins une partie du circuit,
   - un dispositif logique (21) de détection d'intrusion apte à activer le dispositif de protection au vu des signaux résultats,

   **caractérisé en ce que** le dispositif de protection comprend des moyens de mise à feu (31) qui permettent d'amorcer une micro-charge pyrotechnique locale ou globale (30) à l'aide de l'énergie électrique stockée dans la source d'énergie, de manière permanente.

2. Dispositif selon la revendication 1, dans lequel les moyens de mise à feu comprennent une amorce électrique (31) ou une mèche.

3. Dispositif selon la revendication 2, qui est entièrement recouvert par une micro-charge pyrotechnique.

**4.** Dispositif selon la revendication 2, dans lequel au moins une micro-charge (30) et au moins une amorce (31) sont associées à au moins un élément du circuit.

**5.** Dispositif selon la revendication 2, dans lequel le circuit constitue une puce dans laquelle les micro-charges (30) et amorces (31) sont situées dans le substrat de cette puce.

**6.** Dispositif selon la revendication 5, dans lequel les micro-charges (30) et amorces (31) sont disposées dans des micro-cavités existant en face arrière du substrat.

**7.** Dispositif selon la revendication 2, dans lequel le circuit constitue une puce dans laquelle les micro-charges (30) et amorces (31) sont situées dans la couche d'implantation des transistors.

**8.** Dispositif selon la revendication 2, dans lequel lé circuit constitue une puce dans laquelle les micro-charges (30) et amorces (31) sont situées dans une couche métal de celle-ci.

**9.** Dispositif selon la revendication 2, dans lequel au moins un ensemble micro-charge (30)/amorce (31) est associé à un micro-fusible (45).

**10.** Dispositif selon la revendication 2 comportant au moins une micro-bobine' (46) couplée à distance à une micro-bobine (47) d'un circuit résonant intégré dans une micro-charge (30).

**11.** Dispositif selon la revendication 1, dans lequel la source d'énergie (11) est intégrée au circuit électronique.

**12.** Dispositif selon la revendication 1, dans lequel la source d'énergie (11) est un accumulateur.

**13.** Dispositif selon la revendication 1, dans lequel au moins un capteur est intégré au circuit électronique.

**14.** Dispositif selon la revendication 1, dans lequel tout le dispositif est intégré au circuit électronique.

**15.** Dispositif selon la revendication 1, dans lequel au moins un capteur (12, 13, 14) est apte à mesurer une grandeur physique caractérisant le circuit ou l'environnement du circuit

**16.** Dispositif selon la revendication 1, dans lequel au moins un capteur (12, 13, 14) est apte à mesurer une grandeur physique caractérisant la communication entrant ou sortant dudit dispositif.

**17.** Dispositif selon la revendication 1, dans lequel au moins un capteur (12, 13, 14) est apte à mesurer le niveau d'énergie de la source d'énergie afin d'émettre un signal d'avertissement de demande de recharge ou d'activation du dispositif de protection.

**18.** Dispositif selon la revendication 1, dans lequel au moins un capteur (12, 13, 14) est apte à mesurer une grandeur physique caractérisant la liaison électrique source d'énergie (11) - dispositif logique de prise de décision.

**19.** Utilisation du dispositif selon l'une quelconque des revendications précédentes dans une carte à puce.

**Claims**

**1.** Secure electronic device comprising at least an electronic circuit containing information to be protected, including:

- an energy source (11);
- at least one sensor (12, 13, 14) capable of measuring a determined physical magnitude and outputting a value representative of this magnitude,
- means (15, 16, 17) of comparing each value with at least one predefined threshold (ref1, ref2, ref3) outputting result signals,
- a device (20) for protection of information comprising means for triggering destruction of at least part of the circuit,
- a logical intrusion detection device (21) capable of activating the protection device after seeing the result signals,

**characterized in that** the protection device comprises firing means (31) that enable priming of a local or global pyrotechnic micro-charge (30) using electrical energy permanently stored in the energy source.

**2.** Device according to claim 1, in which the firing means include an electrical primer (31) or a fuse.

**3.** Device according to claim 2, which is fully covered by a pyrotechnic micro-charge.

**4.** Device according to claim 2, in which at least a micro-charge (30) and at least a primer (31) are associated with at least one element of the circuit.

**5.** Device according to claim 2, in which the circuit is composed of a chip in which the micro-charges (30) and the primers (31) are located in the substrate of this chip.

**6.** Device according to claim 5, in which the micro-charges (30) and the primers (31) are located in micro-cavities on the back face of the substrate.

7. Device according to claim 2, in which the circuit is composed of a chip in which the micro-charges (30) and the primers (31) are located in the layer in which the transistors are installed.

8. Device according to claim 2, in which the circuit is composed of a chip in which the micro-charges (30) and the primers (31) are located in a metal layer of the chip.

9. Device according to claim 2, in which at least one micro-charge (30) / primer (31) assembly may be associated with a micro-fuse (45).

10. Device according to claim 2, comprising at least one micro-coil (46) coupled remotely to a micro-coil (47) in a resonant circuit integrated in a micro-charge (30).

11. Device according to claim 1, in which the energy source (11) is integrated in the electronic circuit.

12. Device according to claim 1, in which the energy source (11) is an accumulator.

13. Device according to claim 1, in which at least one sensor is integrated in the electronic circuit.

14. Device according to claim 1, in which the entire device is integrated in the electronic circuit.

15. Device according to claim 1, in which at least one sensor (12, 13, 14) is capable of measuring a physical magnitude characterising the circuit or the circuit environment.

16. Device according to claim 1, in which at least one sensor (12, 13, 14) is capable of measuring a physical magnitude characterising the input or output communication to or from the said device.

17. Device according to claim 1, in which at least one sensor (12, 13, 14) is capable of measuring the energy level of the energy source in order to send a warning signal for a request to recharge or activate the protection device.

18. Device according to claim 1, in which at least one sensor (12, 13, 14) is capable of measuring a physical magnitude characterising the electrical connection between the energy source (11) and the logical decision-making device.

19. Device to be implemented in a smart card, according to any one of the previous claims.

**Patentansprüche**

1. Gesicherte elektronische Vorrichtung mit wenigstens einer zu schützende Daten enthaltenden elektronischen Schaltung, umfassend:

    - eine Energiequelle (11),
    - wenigstens einen Sensor (12, 13, 14), fähig eine bestimmte physikalische Größe zu messen und einen repräsentativen Wert dieser Größe zu liefern,
    - Einrichtungen (15, 16, 17) zum Vergleichen jedes Werts mit wenigstens einer vorher definierten Schwelle (ref1, ref2, ref3), die Resultat-Signale liefern,
    - eine Vorrichtung (20) zum Schutz der Daten, Einrichtungen zur Zerstörungssteuerung wenigstens eines Teils der Schaltung umfassend,
    - eine logische Vorrichtung (21) zur Intrusionsdetektion, fähig bei Resultat-Signalen die Schutzeinrichtung zu aktivieren,

    **dadurch gekennzeichnet, dass** die Schutzeinrichtung Zündungseinrichtungen (31) umfasst, die ermöglichen, mit Hilfe der in der Energiequelle permanent gespeicherten elektrischen Energie eine lokale oder globale pyrotechnische Mikroladung (30) zu zünden.

2. Vorrichtung nach Anspruch 1, bei der die Zündungseinrichtungen einen elektrischen Zünder (31) oder eine Zündschnur bzw. ein ihr entsprechendes Mittel umfassen.

3. Vorrichtung nach Anspruch 2, die ganz von einer pyrotechnischen Mikroladung bedeckt ist.

4. Vorrichtung nach Anspruch 2, bei der wenigstens eine Mikroladung (30) und wenigstens ein Zünder (31) wenigstens einem Element der Schaltung zugeordnet sind.

5. Vorrichtung nach Anspruch 2, bei der die Schaltung einen Chip bildet, bei dem die Mikroladungen (30) und Zünder (31) sich im Substrat dieses Chips befinden.

6. Vorrichtung nach Anspruch 5, bei dem die Mikroladungen (30) und Zünder (31) sich in Mikrohohlräumen auf der Rückseite des Substrats befinden.

7. Vorrichtung nach Anspruch 2, bei der die Schaltung einen Chip bildet, bei dem die Mikroladungen (30) und Zünder (31) sich in der Implantationsschicht der Transistoren befinden.

8. Vorrichtung nach Anspruch 2, bei der die Schaltung einen Chip bildet, bei dem die Mikroladungen (30) und Zünder (31) sich in einer Metallschicht von diesem befinden.

9. Vorrichtung nach Anspruch 2, bei dem wenigstens eine aus Mikroladung (30) und Zünder (31) bestehende Einheit einer Mikrosicherung (45) zugeordnet ist.

10. Vorrichtung nach Anspruch 2 mit wenigstens einer Mikrospule (46), distanzgekoppelt mit einer Mikrospule (47) eines in eine Mikroladung (30) integrierten Resonanzkreises.

11. Vorrichtung nach Anspruch 1, bei der die Energiequelle (11) in die elektronischen Schaltung integriert ist.

12. Vorrichtung nach Anspruch 1, bei der die Energiequelle (11) ein Akkumulator ist.

13. Vorrichtung nach Anspruch 1, bei der wenigstens ein Sensor in die elektronische Schaltung integriert ist.

14. Vorrichtung nach Anspruch 1, bei der die gesamte Vorrichtung in die elektronische Schaltung integriert ist.

15. Vorrichtung nach Anspruch 1, bei der wenigstens ein Sensor (12, 13, 14) fähig ist, eine physikalische Größe zu messen, die die Schaltung oder die Umgebung der Schaltung charakterisiert.

16. Vorrichtung nach Anspruch 1, bei der wenigstens ein Sensor (12, 13, 14) fähig ist, eine physikalische Größe zu messen, die die Eingangs- und Ausgangskommunikation der Vorrichtung charakterisiert.

17. Vorrichtung nach Anspruch 1, bei der wenigstens ein Sensor (12, 13, 14) fähig ist, den Energiepegel der Energiequelle zu messen, um ein Signal zur Mitteilung von Aufladungsbedarf oder zur Aktivierung der Schutzvorrichtung auszusenden.

18. Vorrichtung nach Anspruch 1, bei der wenigstens ein Sensor (12, 13, 14) fähig ist, eine physikalische Größe zu messen, die die elektrische Verbindung zwischen der Energiequelle (11) und der logischen Entscheidungsvorrichtung charakterisiert.

19. Nutzanwendung der Vorrichtung nach einem der vorangehenden Ansprüche in einer Chipkarte.

EP 1 493 126 B1

FIG. 1

FIG. 2

FIG. 3

FIG. 4

FIG. 5

FIG. 6

FIG. 7

FIG. 8

## FIG. 9

## FIG. 10